(19) **Europäisches Patentamt**
**European Patent Office**
**Office européen des brevets**

(11) **EP 1 923 486 A2**

(12) **EUROPEAN PATENT APPLICATION**

(43) Date of publication:
**21.05.2008 Bulletin 2008/21**

(51) Int Cl.:
*C23C 28/04* (2006.01)    *C23C 30/00* (2006.01)
*B23B 27/00* (2006.01)    *C23C 14/06* (2006.01)

(21) Application number: **07119779.2**

(22) Date of filing: **31.10.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(30) Priority: **20.11.2006 SE 0602457**

(71) Applicant: **Sandvik Intellectual Property AB
811 81 Sandviken (SE)**

(72) Inventors:
• **David, Emmanuel
  811 36 Sandviken (SE)**
• **Hessman, Ingemar
  811 54 Sandviken (SE)**

(74) Representative: **Hägglöf, Henrik
  Sandvik Intellectual Property AB
  811 81 Sandviken (SE)**

(54) **Coated inserts for milling of compacted graphite iron**

(57)    The present invention discloses coated milling inserts particularly useful for milling of compacted graphite iron under wet conditions at moderate cutting speeds comprising a cemented carbide body and a coating. The cemented carbide body comprises WC, 7.3-7.9 wt-% Co and 1.0-1.8 wt-% cubic carbides of Ta and Nb and a highly W-alloyed binder phase. The radius of the uncoated cutting edge is 25-45 $\mu$m.
    The coating comprises
- a first <1 $\mu$m $TiC_xN_yO_z$ layer adjacent to the cemented carbide having a composition of x+y=1, x>= 0,
- a second 1-2 $\mu$m $TiC_xN_yO_z$ layer having a composition of x>0.4, y>0.4 and 0=<z<0.1
- a third <1 $\mu$m $TiC_xN_yO_z$ layer having a composition of x+y+z>=1 and z>0
- an $\alpha$-$Al_2O_3$-layer with a thickness of 2.1-3.3 $\mu$m and
- a further 0.1-2.5 $\mu$m, thick layer of TiN missing along the edge line.

EP 1 923 486 A2

**Description**

The present invention relates to coated cemented carbide cutting tool inserts particularly useful for milling of compacted graphite iron (CGI) under wet and dry conditions at moderate to high cutting speeds.

Compacted graphite iron (CGI) sometimes also called vermicular iron, is a material becoming more and more interesting for environmental reasons in engine manufacturing. With 75% higher tensile strength and around 45% greater stiffness than alloyed grey cast iron, CGI is particularly suitable for complex components subjected to mechanical and/or thermal loading such as in diesel engine blocks and cylinder heads where cleaner emissions call for higher internal operating pressures. CGI allows the development of lighter, stronger engine blocks and heads.

Recent trends in CGI engine development have also been towards increased power density in the engine design. It is exactly what manufacturers want provided that the material can be machined quickly and efficiently with machining processes whose overall cost and cycle times match similar operations for grey cast iron and aluminum components.

CGI has a unique morphology, also called Coral structure, which gives strong adhesion properties between the compacted graphite and the iron matrix. This suppresses crack initiation and propagation in the material and provides increased mechanical properties relative to alloyed grey cast iron and improved thermal conductivity relative to ductile iron. Overall this adds up to improved mechanical properties and a material that is twice as strong as grey cast iron.

CGI can be produced with varying pearlite contents to suit the required application and this has implications for the machining process. More particularly, CGI for engine blocks and heads normally aims at a pearlite content of about 90 vol% and a nodularity of about 20 vol%.

The unique grain structure of CGI is particularly demanding on tool life as machining of CGI tends to demand higher cutting forces, i.e. temperature. It is hard to machine under the same conditions as for alloyed grey cast iron. The pearlitic content is the dominating factor influencing the tool life. Also the amount of carbides influences tool life but to a lower degree.

A dominating problem when machining CGI is the burr formation, which reduces tool life.

A general recommendation for milling of CGI is to do it under dry conditions, if you just consider machining and cost per component, (tool life).

However if you take in to consideration the reliability of the machine, it will be understood that the machine tool builder will not guarantee the functionality of the machine if it is used under dry conditions due to the fact that dry machining creates high temperature, chips, dust etc. High temperature, hot chips and dust might affect the machine and the components.

Due to those reasons, most of the milling of CGI is done as wet milling with a coolant, even if the cost per component increases.

It is an object of the present invention to provide a milling insert particularly useful at moderate to high speed milling of CGI which an ability to carry out these operations at cycle times and at a cost that match similar processes on alloyed cast grey iron under dry and wet conditions.

It has now surprisingly been found that by balancing the substrate and coating properties to meet the loads in the milling application cutting tool insert have been obtained with excellent cutting performance when wet milling compacted graphite iron using fluid coolant or at dry conditions at moderate to high cutting speeds.

The cutting tool inserts according to the present invention show improved tool life. The criteria's for milling of CGI is normally surface finish of components, burrs, etc, depending on the presence of thermal cracks and flank wear. Surprisingly, it has been found that the number of thermal cracks is reduced and the tool life is increased.

The cutting tool inserts according to the present invention have a cemented carbide body with a rather highly W-alloyed binder phase and with a well balanced chemical composition and grain size of the WC, $TiC_xN_y$-layer, an $\alpha$-$Al_2O_3$-layer, and a TiN-layer with smooth cutting edges obtained by brushing the edges.

According to the present invention coated cutting tool inserts are provided consisting of a cemented carbide body with a composition of 7.3-7.9 wt-% Co, preferably 7.6 wt-% Co, 1.0-1.8 wt-% cubic carbides, preferably 1.4-1.7 wt-% cubic carbides of the metals Ta and Nb and balance WC. The average grain size of the WC is 1.5-2.5 $\mu$m, preferably about 1.8 $\mu$m.

The cobalt binder phase is rather highly alloyed with W. The content of W in the binder phase is expressed as the

$$CW\text{-}ratio = magnetic\text{-}\% \ Co \ / \ wt\text{-}\% \ Co$$

where magnetic-% Co is the weight percentage of magnetic Co and wt-% Co is the weight percentage of Co in the cemented carbide. The CW-value is a function of the W content in the Co binder phase. A CW-value of about 1 corresponds to a low W-content in the binder phase and a CW-value of about 0.75-0.8 corresponds to a high W-content in the binder phase.

According to the present invention, improved cutting performance is achieved if the cemented carbide body has a CW-ratio of 0.86-0.94.

The radius of the uncoated cutting edge is 25-45 $\mu$m.

The cemented carbide insert is at least partly coated with a 4.7-6.8 $\mu$m thick coating including at least three layers of $TiC_xN_yO_z$. The $TiC_xN_yO_z$-layers have a total thickness of 2.1-3.3 $\mu$m and comprise:

- A first, <1 $\mu$m $TiC_xN_yO_z$ layer adjacent to the cemented carbide having a composition of x+y=1, x>= 0, preferably x<0.2 and z=0.
- A second, 1-2 $\mu$m $TiC_xN_yO_z$ layer having a composition of x>0.4, y>0.4 and 0=<z<0.1, preferably z=0.
- A third, <1 $\mu$m $TiC_xN_yO_z$ layer adjacent to the $\alpha$-$Al_2O_3$-layer having a composition of x+y+z>=1, preferably x+y+z=1, and z>0, preferably z>0.2, and preferably y<0.2.
- An $\alpha$-$Al_2O_3$-layer with a thickness of 2.1-3.3 $\mu$m
- A further 0.1-2.5 $\mu$m, preferably 1.2 $\mu$m thick layer of TiN, preferably missing along the cutting edge. The underlying alumina layer may also be partly missing along the cutting edge.

The present invention also relates to a method of making coated cutting tool inserts consisting of a cemented carbide body with a composition of 7.3-7.9 wt-% Co, preferably 7.6 wt-% Co, 1.0-1.8 wt-% cubic carbides, preferably 1.4-1.7 wt-% cubic carbides of the metals Ta and Nb and balance WC. The average grain size of the WC is 1.5-2.5 $\mu$m, preferably about 1.8 $\mu$m.

After blasting the inserts to an edge radius of 25-45 $\mu$m the following coating is deposited

- A first, <1 $\mu$m $TiC_xN_yO_z$ layer adjacent to the cemented carbide having a composition of x+y=1, x>= 0, preferably x<0.2, and z=0 using known CVD-methods,
- A second, 1-2 $\mu$m $TiC_xN_yO_z$ layer having a composition of x>0.4, y>0.4 and 0=<z<0.1, preferably z=0 using preferably MTCVD-technique, using acetonitrile as the carbon and nitrogen source for forming the layer at a temperature of 700-900 °C. The exact conditions, however, depend to a certain extent on the design of the equipment used,
- A third, <1 $\mu$m $TiC_xN_yO_z$ layer adjacent to the $\alpha$-$Al_2O_3$-layer having a composition of x+y+z>=1, preferably x+y+z=1, and z>0, preferably z>0.2, and preferably y<0.2.
- An $\alpha$-$Al_2O_3$-layer with a thickness of 2.1-3.3 $\mu$m using known CVD-methods and
- a further 0.1-2.5 $\mu$m, preferably 1.2 $\mu$m thick layer of TiN.

The edge line is brushed with brushes based on, e.g., SiC as disclosed, e.g., in US 5,861,210. The TiN-layer is preferably removed along the cutting edge and the alumina layer may be partly removed along the cutting edge.

The invention also relates to the use of cutting tool inserts according to the above for milling of compacted graphite iron, either dry milling or wet milling using fluid coolant, at a cutting speed of 80-280 m/min, depending on length of engagement, and a feed of 0.1-0.35 mm/tooth depending on cutting speed and insert geometry.

Example 1

A. Cemented carbide milling inserts type TNEF 1204AN-KX in accordance with the invention with the composition 7.6 wt-% Co, 1.25 wt-% TaC, 0.30 wt-% NbC and balance WC with average grain size of 1.8 $\mu$m, with a binder phase alloyed with W corresponding to a CW-ratio of 0.9 were coated as follows after having been blasted to an edge radius of 35 $\mu$m:

a first layer of 0.5 $\mu$m $TiC_{0.05}N_{0.95}$ using known CVD method using a reaction mixture consisting of $TiCl_4$, $H_2$ and $N_2$, a second layer of 1.7 $\mu$m columnar $TiC_{0.55}N_{0.45}$ using the well-known MTCVD-technique, temperature 885-850 °C and $CH_3CN$ as the carbon/nitrogen source,

a third, bonding layer of 0.5 $\mu$m $TiC_{0.5}O_{0.5}$ with needle shaped grains,

a fourth layer consisting of 2.7 $\mu$m $\alpha$-$Al_2O_3$ and finally a top layer of about 1.3 $\mu$m TiN using known CVD-technique. XRD-measurements confirmed that the $Al_2O_3$-layer consisted to 100 % of the $\alpha$-phase.

After the coating cycle the edge line of the inserts was subjected to a brushing operation using SiC brushes.

B. Sandvik GC4020 commercial grade

C. Cemented carbide milling inserts of style TNEF1204AN-KM and with the composition 6 % Co and balance WC and an edge radius of 50 $\mu$m were coated with the same coating as A.

Example 2

Inserts A, B and C were subjected to the following performance test:

Operation: Face milling - roughing
Work-piece: Diesel engine block top face
Material: CGI 85 % pearlite and 23 % nodularity
Tool: Sandvik Coromant R260.31-315
Criterion: Surface finish (burr formation).

Cutting data
Cutting speed: Vc= 200 m/min
Feed rate/tooth: Fz= 0.20 mm/rev
Depth of cut: Ap= 4 mm
Dry condition

Results: Tool-life, number of engine blocks
Grade A: (invention) 874
Grade B: Sandvik GC 4020 695
Grade C: Reference 456

Example 3

Inserts A, B and C were subjected to the following performance test:

Operation: Face milling - roughing
Work-piece: Cylinder head
Material: CGI 90 % Pearlitic and nodularity 17 %
Tool: Sandvik Coromant R260.31-250
Criterion: Surface finish: (Burr formation)

Cutting data
Cutting speed: Vc= 178 m/min
Feed rate/tooth: Fz= 0.18 mm/rev
Depth of cut: Ap= 3.5 mm

Wet condition

Insert-style: TNEF 1204AN-KX
Results: Tool-life, number of cylinder heads
Grade A: (invention) 748
Grade B: Sandvik GC 4020 576
Grade C: Reference 487

**Claims**

1. A cutting tool insert for milling of compacted graphite iron under dry or wet conditions at moderate to high cutting speeds comprising a cemented carbide body and a coating **characterized in that** said cemented carbide body comprising WC, 7.3-7.9 wt-% Co and 1.0-1.8 wt-% cubic carbides of Ta and Nb and a highly W-alloyed binder phase with a CW-ratio of 0.86-0.94 and radius of the uncoated cutting edge of 25-45 $\mu$m
and **in that** said coating comprising:

  - a first, <1 $\mu$m, $TiC_xN_yO_z$ layer adjacent to the cemented carbide having a composition of x+y=1, x>= 0, preferably x<0.2 and z=0,
  - a second, 1-2 $\mu$m, $TiC_xN_yO_z$ layer having a composition of x>0.4, y>0.4 and 0=<z<0.1, preferably z=0,
  - a third, <1 $\mu$m, $TiC_xN_yO_z$ layer having a composition where x+y+z>=1, preferably x+y+z=1, and z>0, preferably z>0.2, and preferably y<0.2,
  - an $\alpha$-$Al_2O_3$-layer with a thickness of 2.1-3.3 $\mu$m and
  - a further 0.1-2.5 $\mu$m, preferably 1.2 $\mu$m thick layer of TiN.

2. Milling insert according to claim 1
   **characterized in that** the cemented carbide contains 1.4-1.7 wt-% carbides of Ta and Nb.

3. Milling insert according to any of the preceding claims
   **characterized in that** the outermost TiN-layer is missing along the cutting edge.

4. Method of making a milling insert for milling of compacted graphite iron under dry or wet conditions at moderate to high cutting speeds comprising a cemented carbide body and a coating
   **characterised in that** the WC-Co-based cemented carbide body comprising WC, 7.3-7.9 wt-% Co and 1.0-1.8 wt-% cubic carbides of Ta and Nb and a highly W-alloyed binder phase with a CW-ratio of 0.86-0.94, the method comprising the steps of:

  - treating the inserts to an edge radius of 25-45 $\mu$m
  - depositing by a CVD-method a first <1 $\mu$m $TiC_xN_yO_z$ layer adjacent to the cemented carbide having a composition of x+y=1, x>= 0, preferably x<0.2 and z=0,
  - depositing by a MTCVD-technique a second 1-2 $\mu$m $TiC_xN_yO_z$ layer having a composition of x>0.4, y>0.4 and 0=<z<0.1, preferably z=0, wherein the MTCVD-technique uses acetonitrile as a source of carbon and nitrogen for forming a layer in a temperature range of 700-900°C,
  - depositing a third <1 $\mu$m $TiC_xN_yO_z$ layer having a composition of x+y+z>=1, preferably x+y+z=1, and z>0, preferably z>0.2, and preferably y<0.2
  - depositing using known CVD-methods an $\alpha$-$Al_2O_3$-layer with a thickness of 2.1-3.3 $\mu$m and
  - depositing using known CVD-methods a further 0.1-2.5 $\mu$m, preferably 1.2 $\mu$m thick layer of TiN.

5. Method according to the previous claim
   **characterized in that** said cemented carbide body contains 1.4-1.7 wt-% carbides of Ta and Nb.

6. Method according to any of the claims 4 and 5
   **characterized in that** the outermost TiN-layer is removed by brushing with SiC brushes along the cutting edge.

7. Use of a cutting tool insert according to claims 1-3 for dry or wet milling using fluid coolant of compacted graphite iron at a cutting speed of 80-280 m/min, depending on length of engagement and a feed of 0.1-0.35 mm/tooth depending on cutting speed and insert geometry.

**EP 1 923 486 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5861210 A